(19) Europäisches Patentamt
European Patent Office
Office européen des brevets

(11) EP 2 653 879 B1

(12) **EUROPÄISCHE PATENTSCHRIFT**

(45) Veröffentlichungstag und Bekanntmachung des Hinweises auf die Patenterteilung:
**23.08.2017 Patentblatt 2017/34**

(51) Int Cl.:
*H02S 50/10* (2014.01)     *G01R 31/28* (2006.01)
*G01R 31/40* (2014.01)

(21) Anmeldenummer: **13162207.8**

(22) Anmeldetag: **03.04.2013**

(54) **VORRICHTUNG ZUM AUSGEBEN EINES GLEICHSPANNUNGSSIGNALS MIT NICHTLINEARER STROM-SPANNUNGSKENNLINIE**

DEVICE FOR THE SIMULTANEOUS OUTPUT OF A DIRECT VOLTAGE SIGNAL WITH A NON-LINEAR POWER-VOLTAGE CURVE

DISPOSITIF D'ÉMISSION D'UN SIGNAL DE TENSION CONTINUE AYANT UNE CARACTÉRISTIQUE TENSION/COURANT NON LINÉAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **19.04.2012 DE 102012103456**

(43) Veröffentlichungstag der Anmeldung:
**23.10.2013 Patentblatt 2013/43**

(73) Patentinhaber: **IPH Institut "Prüffeld für elektrische Hochleistungstechnik" GmbH**
**12681 Berlin (DE)**

(72) Erfinder: **Borchert, Rainer**
**16356 Ahrensfelde (DE)**

(74) Vertreter: **Zimmermann & Partner**
**Patentanwälte mbB**
**Postfach 330 920**
**80069 München (DE)**

(56) Entgegenhaltungen:
**DE-A1- 2 018 181**     **DE-A1- 2 233 612**
**DE-B1- 2 052 251**     **GB-A- 1 457 654**
**JP-A- H07 234 716**     **KR-A- 20090 046 438**
**US-A1- 2009 133 735**

- **Heinrich Häberlin: "Bau eines Solargenerator-Simulators von 100 kW", Staffelstein 23. Symposium Photovoltaische Solarenergie Staffelstein 2008, 7. März 2008 (2008-03-07), XP002699927, Staffelstein Gefunden im Internet: URL:http://www.pvtest.ch/fileadmin/user_up load/lab1/pv/publikationen/SIM-100-Beitrag -K_F.pdf [gefunden am 2013-07-04]**

EP 2 653 879 B1

**Beschreibung**

Die vorliegende Erfindung betrifft eine Vorrichtung zum Ausgeben eines Gleichspannungssignals mit nichtlinearer Strom-Spannungskennlinie, insbesondere zur Prüfung eines Prüflings sowie einen Simulator zum Prüfen von elektrotechnischen Geräten und Anlagen, insbesondere von Photovoltaikkomponenten.

Zum Entwickeln und Prüfen elektrotechnischer Geräte und Anlagen werden in entsprechenden Test- bzw. Prüfvorrichtungen, die im Folgenden auch als Simulatoren bezeichnet werden, häufig Spannungsquellen benötigt, die einen nichtlinearen Spannungs-Strom-Kennlinienverlauf nachbilden, dem die elektrotechnischen Geräte und Anlagen im Betrieb ausgesetzt sein können. Beispielsweise werden für die Entwicklung und Prüfung der Komponenten von Photovoltaik-Anlagen, wie z.B. Schutzeinrichtungen und Schaltgeräten, Spannungsquellen benötigt, die nichtlineare Spannungs-Strom-Kennlinienverläufe von Solarmodulen nachbilden können.

Derartige Spannungsquellen werden gegenwärtig durch aufwändige elektronische Schaltungen mit Konstantstromquellen realisiert, welche von einer Gleichspannungsquelle, z.B. von einem transformatorgespeisten Gleichrichter, mit linearer Kennlinie gespeist werden und durch entsprechende Ansteuerung aktiver leistungselektronischer Baugruppen die gewünschte nichtlineare Kennlinie erzeugen. Schaltungsanordnungen zur Nachbildung einer Solarzellen-Kennlinie sind aus der Patentschrift GB 1 457654, sowie aus den Offenlegungsschriften DE 2 052 251 und DE 2 018 181 bekannt. Die Leistung dieser elektronischen Prüfquellen liegt z.Zt. bei maximal etwa 150 kW (bei 1500 V). Sie wird von den Kennwerten der leistungselektronischen Bauelemente, meist Transistoren, bestimmt und begrenzt. Das ist für die Prüfung von Kurzschlussschutzeinrichtungen und Schaltgeräten mitunter nicht ausreichend.

Im Hinblick auf das oben Gesagte, schlägt die vorliegende Erfindung eine Vorrichtung zur Ausgabe eines Gleichspannungssignals mit nichtlinearer Strom-Spannungskennlinie gemäß Anspruch 1 und einen Simulator zum Prüfen von elektrotechnischen Geräten und Anlagen gemäß Anspruch 10 vor.

Gemäß einem Ausführungsbeispiel umfasst eine Vorrichtung zum Ausgeben eines Gleichspannungssignals mit nichtlinearer Strom-Spannungskennlinie, einen ersten Signalausgang, einen zweiten Signalausgang, eine erste lineare Spannungsquelle, eine zweite lineare Spannungsquelle und ein Schaltelement. Die erste lineare Spannungsquelle umfasst einen Minuspol und einen Pluspol und ist eingerichtet ist, zwischen dem Minuspol und dem Pluspol eine erste Ausgangsgleichspannung auszugeben. Die zweite lineare Spannungsquelle umfasst einen Minuspol und einen Pluspol und ist eingerichtet, zwischen dem Minuspol und dem Pluspol eine zweite Ausgangsgleichspannung auszugeben, wobei der Pluspol der zweiten linearen Spannungsquelle mit dem Minuspol der ersten linearen Spannungsquelle verbunden ist. Der erste Signalausgang ist über einen ersten Vorwiderstand mit dem Pluspol der ersten linearen Spannungsquelle verbunden. Der zweite Signalausgang ist über einen zweiten Vorwiderstand mit dem Minuspol der zweiten linearen Spannungsquelle verbunden. Das Schaltelement hat einem ersten Anschluss und einem zweiten Anschluss, der mit dem zweiten Signalausgang verbunden ist, wobei der erste Anschluss mit dem Minuspol der ersten linearen Spannungsquelle verbunden ist, und wobei sich das Schaltelement in einem nichtleitenden Zustand befindet, wenn zwischen dem zweiten Anschluss und dem ersten Anschluss eine positive Spannungsdifferenz anliegt. Damit wird eine einfache Spannungsquelle mit nichtlinearer Strom-Spannungskennlinie bereitgestellt, die ohne aufwändige elektronische Schaltungen (z. B. Konstantstromquellen) auch für hohe Leistungen realisiert werden kann.

Typischerweise umfasst das Schaltelement eine Diode, typischerweise eine Leistungsdiode, die in Durchlassrichtung zwischen dem Pluspol der zweiten linearen Spannungsquelle und dem Minuspol der zweiten linearen Spannungsquelle angeordnet ist. Dies ermöglicht auf einfache Weise ein schnelles Zu- bzw. Abschalten der zweiten linearen Spannungsquelle zur ersten linearen Spannungsquelle in Abhängigkeit vom Widerstand einer zwischen den ersten Signalausgang und den zweiten Signalausgang geschalteten Last. Dadurch wird die Verwendung der Vorrichtung als Spannungsquelle in einem Simulator für einen Prüfling ermöglicht. Das Schaltelement kann insbesondere aus einer Diode, typischerweise einer Leistungsdiode, bestehen. Die Geschwindigkeit des Umschaltvorgangs wird dann im Wesentlichen nur durch die hohe Schaltgeschwindigkeit der Diode begrenzt. Durch die Verwendung der Diode kann außerdem auf leistungsbegrenzende aktive Bauelemente, wie z.B. Transistoren, verzichtet werden. Dies ermöglicht, höhere Prüfleistungen mit nichtlinearer Quellencharakteristik bereitzustellen.

Gemäß einer Weiterbildung wird ein Schaltpunkt zwischen dem nichtleitenden Zustand und einem leitenden Zustand des Schaltelements mit einer Genauigkeit von 5% oder besser, z.B. mit einer Genauigkeit von 3% oder besser, auf einem Punkt maximaler Leistung der nichtlinearen Strom-Spannungsstromkennlinie eingestellt ist. Dadurch kann die nichtlineare Strom-Spannungsstromkennlinie mit hinreichender Genauigkeit an die nichtlineare Strom-Spannungsstromkennlinie angepasst werden, der ein Prüfling, z.B. eine Sicherung, ein Schaltgerät oder ein Ableiter, im normalen Betrieb ausgesetzt sein kann. Beispielsweise lässt sich so die nichtlineare Strom-Spannungsstromkennlinie von Photovoltaikmodulen für Testzwecke von z.B. Schaltgeräten und Sicherungen von Photovoltaikanlagen mit hinreichender Genauigkeit in einem Simulator erzeugen.

Gemäß noch einer Weiterbildung ist der erste Vorwiderstand und / oder der zweite Vorwiderstand ein regelbarer Widerstand. Dies ermöglicht, die nichtlineare Strom-Spannungsstromkennlinie einfach anzupassen.

Bei der ersten lineare Spannungsquelle und / oder der zweiten lineare Spannungsquelle kann es sich z.B. um eine 6-Pulsgleichspannunsgquelle handeln. Damit können hohe Leistungen auf einfache Art und Weise bereitgestellt werden. Die zweite Ausgangsgleichspannung kann - je nach angestrebter nichtlineare Strom-Spannungsstromkennlinie - gleich oder größer als die erste Ausgangsgleichspannung sein, z.B. etwa 3-mal so groß wie die erste Ausgangsgleichspannung, wenn die angestrebte nichtlineare Strom-Spannungsstromkennlinie der eines Photovoltaikmoduls entsprechen soll.

Typischerweise ist die erste lineare Spannungsquelle und / oder die zweite lineare Spannungsquelle eine schaltbare lineare Spannungsquelle. Dadurch kann die Leistungsabgabe der Spannungsquellen in einem Simulator nur auf die erforderliche Prüfzeiten eingeschränkt werden und so elektrische Verluste und Erwärmungen reduziert werden.

Typischerweise ist die Vorrichtung zur Ausgabe eines Gleichspannungssignals mit nichtlinearer Strom-Spannungskennlinie eingerichtet, bei einem Kurzschluss zwischen dem ersten Signalausgang und dem zweiten Signalausgang Gleichspannungssignale von mindestens 100 A, noch typischer von mehr als 200 A, z.B. mehr als 500 A bereitzustellen. Dies ermöglicht die Verwendung der Vorrichtung als Spannungsquelle in einem Simulator für Leistungsprüflinge.

Typischerweise ist die Vorrichtung zur Ausgabe eines Gleichspannungssignals mit nichtlinearer Strom-Spannungskennlinie eingerichtet, in unbelastetem Zustand zwischen dem zweiten Signalausgang und dem ersten Signalausgang Gleichspannungssignale von mindestens 1000 V, z.B. von mehr als 1500 V bereitzustellen. Dies ermöglicht die Verwendung der Vorrichtung als Spannungsquelle in einem Simulator für Leistungsprüflinge.

Typischerweise ist die Vorrichtung zur Ausgabe eines Gleichspannungssignals mit nichtlinearer Strom-Spannungskennlinie eingerichtet, zwischen dem zweiten Signalausgang und dem ersten Signalausgang Gleichspannungssignale von Gleichspannungssignale von mindestens 100 kW, noch typischer von mindestens 200 kW, noch typischer von mindestens 400 kW, z.B. von mindestens 600 kW bereitzustellen. Dies ermöglicht die Verwendung der Vorrichtung als Spannungsquelle in einem Simulator für Leistungsprüflinge. Beispielsweise kann die Vorrichtung in einem Punkt maximaler Leistung der nichtlinearen Strom-Spannungskennlinie etwa 386 kW bereitstellen. Die bereitgestellte nichtlineare Strom-Spannungskennlinie entspricht dann einem typischen Photovoltaikmodul mit 1575 V Leerlaufspannung und einem Kurzschlussstrom von 500 A, wobei die Leistung in Punkt maximaler Leistung etwa 49% des Produktes aus Kurzschlussstrom und Leerlaufspannung entspricht.

Gemäß einem Ausführungsbeispiel umfasst ein Simulator zum Prüfen von elektrotechnischen Geräten und Anlagen, insbesondere Photovoltaikkomponenten einen ersten Prüfsignalausgang, einen zweiten Prüfsignalausgang, eine erste lineare Spannungsquelle, wobei die erste lineare Spannungsquelle einen Minuspol und einen Pluspol, der mit dem ersten Prüfsignalausgang verbunden ist, umfasst und eingerichtet ist, zwischen dem Pluspol und dem Minuspol eine erste Ausgangsspannung auszugeben, eine zweite lineare Spannungsquelle, wobei die zweite lineare Spannungsquelle einen Minuspol, der mit dem zweiten Prüfsignalausgang verbunden ist, und einen Pluspol, der mit dem Minuspol der ersten linearen Spannungsquelle verbunden ist, umfasst und eingerichtet ist zwischen dem Pluspol und dem Minuspol eine zweite Ausgangsspannung auszugeben, sowie eine Leistungsdiode, die in Durchlassrichtung zwischen dem Pluspol der zweiten linearen Spannungsquelle und dem Minuspol der zweiten linearen Spannungsquelle geschaltet ist. Damit wird ein einfacher Simulator mit nichtlinearer Strom-Spannungskennlinie zwischen dem ersten Prüfsignalausgang und dem zweiten Prüfsignalausgang bereitgestellt, der ohne aufwändige elektronische Schaltungen (z. B. Konstantstromquellen) auch für hohe Leistungen die Prüfung der elektrotechnischen Geräten und Anlagen ermöglicht.

Typischerweise umfasst der Simulator einen ersten Widerstand, der zwischen dem Pluspol der ersten linearen Spannungsquelle und dem ersten Prüfsignalausgang geschaltet ist und / oder einen zweiten Widerstand, der zwischen dem Minuspol der zweiten Spannungsquelle und der Diode sowie dem zweiten Prüfsignalausgang geschaltet ist. Dies ermöglicht auf einfache Weise, dass der Simulator entsprechend eines sich ändernden Widerstands eines zwischen den ersten Prüfsignalausgang und den zweiten Prüfsignalausgang geschalteten Prüflings zwischen zwei linearen Abschnitten der nichtlinearen Strom-Spannungskennlinie schaltet.

Typischerweise ist ein Schaltpunkt zwischen einem sperrenden Zustand der Diode und einem leitenden Zustand der Diode mit einer Genauigkeit von mindestens 5%, d.h. mit einer Genauigkeit von 5% oder besser, auf einem Punkt maximaler Leistung der nichtlinearen Spannungsstromkennlinie des Simulators eingestellt.

Typischerweise ist der erste Widerstand und / oder der zweite Widerstand ein regelbarer Widerstand, wodurch die nichtlineare Strom-Spannungsstromkennlinie einfach angepasst werden kann.

Typischerweise ist der Simulator eingerichtet, zwischen dem ersten Prüfsignalausgang und dem zweiten Prüfsignalausgang Gleichspannungssignale von mindestens 100 kW, noch typischer von mindestens 200 kW, noch typischer von mindestens 400 kW, z.B. von mindestens 600 kW bereitzustellen.

Weitere vorteilhafte Ausgestaltungen, Einzelheiten, Aspekte und Merkmale der vorliegenden Erfindung ergeben sich aus den Unteransprüchen, der Beschreibung sowie den beigefügten Zeichnungen. Darin zeigt:

Fig. 1 eine typische nichtlineare Strom-Spannungskennlinie eines Photovoltaikmoduls;

Fig. 2 eine schematische Darstellung einer Spannungsquelle mit nichtlinearer Strom-Spannungskennlinie, die eine Last versorgt gemäß einem Ausführungsbeispiel;

Fig. 3 eine theoretisch zu erwartende nichtlineare Strom-Spannungskennlinie der Spannungsquelle aus Fig. 2;

Fig. 4 eine nichtlineare Strom-Spannungskennlinie der Spannungsquelle aus Fig. 2 gemäß einem weiteren Ausführungsbeispiel;

Fig. 5 eine Prüfmessung an einem Prüfling mit einem Simulator gemäß einem Ausführungsbeispiel; und

Fig. 6 die Prüfmessung aus Fig. 5 in relativen Einheiten.

Unter dem Begriff "Simulator", wie er vorliegend verwendet wird, soll eine elektrische Prüf- bzw. Testvorrichtung für eine Prüfling insbesondere einen Leistungsprüfling verstanden werden. Typischerweise ist der Simulator eingerichtet dem Prüfling mit elektrischen Prüfsignalen gemäß einer nichtlinearen Strom-Spannungskennlinie zu versorgen, z.B. mit elektrischen Prüfsignalen, die im Wesentlichen einem nichtlinearen Spannungs-Strom-Kennlinienverlauf eines Solarmoduls entspricht.

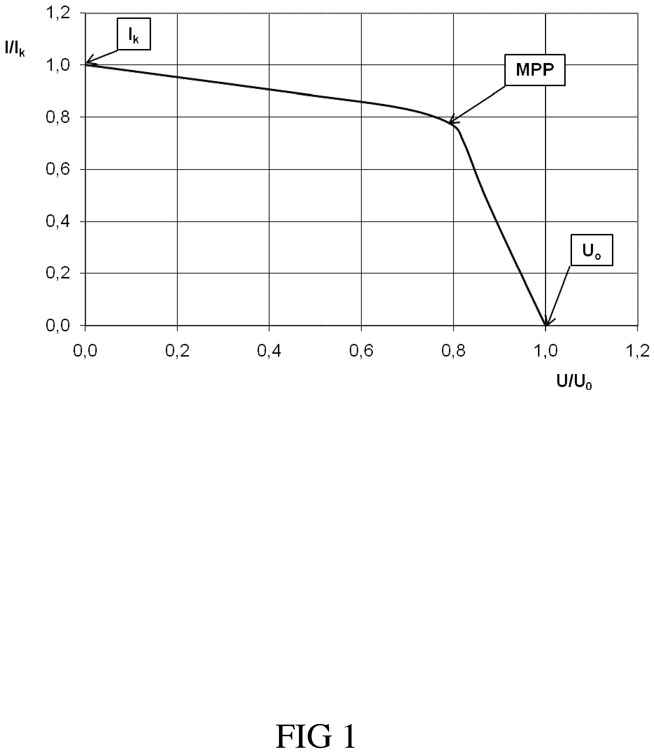

Fig. 1 zeigt eine typische nichtlineare Strom-Spannungskennlinie eines Photovoltaikmoduls in relativen Einheiten. Eine derartige nichtlineare Strom-Spannungskennlinie ist für Prüfungszwecke von Photovoltaikkomponenten auch von einem Simulator mit hinreichender Genauigkeit bereitzustellen. Die Strom-Spannungskennlinie wird durch mindestens 3 Punkte bestimmt: durch den Kurzschlussstrom $I_k$, die Leerlaufspannung $U_0$ und den Punkt maximaler Leistung MPP ("Maximum Power Point"). Sie kann in guter Näherung durch zwei lineare Abschnitte beschrieben werden. Die geforderte Leistung des Simulators im Punkt maximaler Leistung kann dabei insbesondere für die Prüfung von Kurzschluss-Schutzeinrichtungen oder Schaltgeräten mehrere 100 kW betragen. Die Prüfspannung beträgt für den Niederspannungsbereich bis zu 1575 V (1500 V Bemessungsspannung + 5 %), die Prüfströme betragen je nach Anforderung bis zu einigen 100 A.

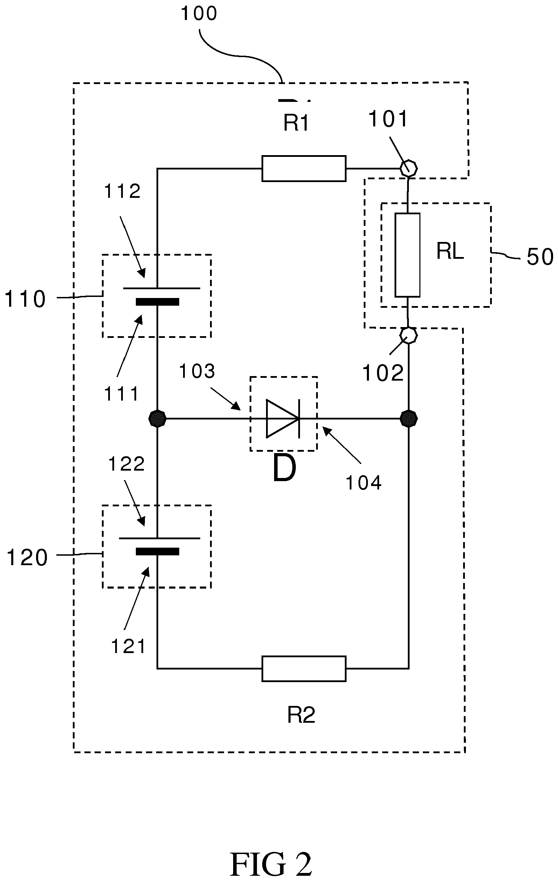

Fig. 2 zeigt eine schematische Darstellung einer Spannungsquelle 100 mit nichtlinearer Strom-Spannungskennlinie mit angeschlossener Last 50, bspw. einem Prüfling. Typischerweise wird die Spannungsquelle 100 in bzw. als Simulators zum Prüfen des Prüflings 50 verwendet.

Dazu wird der Prüfling 50 zwischen einem ersten Signalausgang 101 bzw. erstem Prüfsignalausgang und einem zweiten Signalausgang 102 bzw. zweitem Prüfsignalausgang angeschlossen. Die Spannungsquelle 100 bzw. der Simulator 100 umfasst eine erste lineare Spannungsquelle 110, eine mit der ersten linearen Spannungsquelle 110 in Reihe geschaltete zweite lineare Spannungsquelle und ein Schaltelement D. Die erste lineare Spannungsquelle 110 hat einen Minuspol 111 und einen Pluspol 112, zwischen denen sie eine erste Ausgangsgleichspannung U1 ausgeben kann. Die zweite lineare Spannungsquelle 120 hat einen Minuspol 121 und einen Pluspol 122, zwischen den sie eine zweite Ausgangsgleichspannung U2 ausgeben kann. Der Pluspol 122 der zweiten linearen Spannungsquelle 120 ist mit dem Minuspol 111 der ersten linearen Spannungsquelle 110 verbunden ist. Der erste Signalausgang 101 ist über einen ersten Vorwiderstand R1 mit dem Pluspol 112 der ersten linearen Spannungsquelle 110 verbunden. Der zweite Signalausgang 102 ist über einen zweiten Vorwiderstand R2 mit dem Minuspol 121 der zweiten linearen Spannungsquelle 120 verbunden. Das Schaltelement D hat einem ersten Anschluss 103 und einem zweiten Anschluss 104. Der erste Anschluss 103 ist niederohmig mit dem Minuspol 111 der ersten Spannungsquelle 110 und dem Pluspol 122 der zweiten linearen Spannungsquelle verbunden. Der zweite Ausgang 104 ist niederohmig mit dem zweiten Signalausgang 102 und über den zweiten Vorwiderstand R2 mit dem Minuspol 121 der zweiten linearen Spannungsquelle 120 verbunden ist.

In dem exemplarischen Ausführungsbeispiel von Figur 2 wird das Schaltelement D durch eine Diode, typischerweise eine Leistungsdiode realisiert. Alternativ dazu können aber auch andere spannungssensitive Schalter, d.h. Schalter, die entsprechen einer zwischen ihren beiden Anschlüssen 103, 104 anliegenden Spannung schalten, verwendet werden. Das Schaltelement D befindet sich in einem nichtleitenden Zustand, wenn zwischen dem zweiten Anschluss 104 und dem ersten Anschluss 103 eine positive Spannungsdifferenz anliegt, d. h. wenn zwischen dem zweiten Signalausgang 102 und dem gemeinsamen Bezugspunkt von Minuspol 111 der ersten Spannungsquelle 110 und dem Pluspol 122 der zweiten linearen Spannungsquelle 120 eine positive Spannungsdifferenz anliegt. Das Schaltelement D befindet sich typischerweise in einem leitenden Zustand, wenn zwischen dem zweiten Anschluss 104 und dem ersten Anschluss 103 eine vorgegebene negative Spannungsdifferenz anliegt. Wenn das Schaltelement D als Diode ausgeführt ist, so entspricht die vorgegebene negative Spannungsdifferenz dem Betrage nach der Diodenschwellspannung. Bei Verwendung eines anderen Schaltelements kann sich das Schaltelement D aber auch bei Anliegen gleicher Spannungen an den Anschlüssen 103 und 104 im leitenden Zustand befinden. Die Verwendung einer oder mehrerer Dioden D ermöglicht aber einen einfachen und robusten Aufbau, bei dem sich Schaltpunkt der Diode bzw. der Dioden gut einstellen lässt. Damit kann eine einfache selbstschaltende Spannungsquelle 100 bzw. ein einfacher selbstschaltender Simulator 100 mit nichtlinearer Strom-Spannungskennlinie auch für hohe Leistungen realisiert werden, ohne aufwändige elektronische Schaltungen, z. B. Konstantstromquellen und leistungsbegrenzende Leistungsbauteile wie Transistoren zu verwenden.

Durch das Schaltelement D kann zwischen zwei linearen Kennlinienabschnitten geschaltet werden und so Signale gemäß einer nichtlinearen Strom-Spannungskennlinie zwischen den Signalausgängen 101 und 102 ausgegeben werden. Die Vorwiderstände R1, R2 bilden mit dem Lastwiderstand RL des Prüflings 50 einen Spannungsteiler. Infolge des sich ändernden Lastwiderstandes RL des Prüflings 50, z.B. bei einem Schaltvorgang des Prüflings 50, ändert sich die Spannung am zweiten Ausgang 104 gegenüber der Spannung am ersten Ausgang 103 des Schaltelements D.

Bei offenen Signalausgängen 101, 102 ergibt sich die dort anliegende Leerlaufspannung $U_0$ aus der Summe U1 und der Flußspannung der Diode D. In diesem Zustand fließt über den zweiten Vorwiderstand ein Leerlaufstrom U2/R2.

Da der Vorwiderstand R2 ständig stromdurchflossen ist und bei entsprechend niederohmigen Prüflingen 50 auch der Vorwiderstand R1, werden bei höheren Leistungen typischerweise schaltbarer Spannungsquellen für die erste lineare Spannungsquelle 110 und die zweite lineare Spannungsquelle 120 eingesetzt, um elektrische Verluste und eine Erwärmung zu reduzieren. Für die Prüfung schaltender Komponenten ist es so möglich, die geforderte nichtlineare Kennlinie nur für einen dafür ausreichenden Zeitraum darzustellen, ohne die Widerstände thermisch zu überlasten.

Bei entsprechender Dimensionierung von der Ausgangsspannungen U1, U2, und der Vorwiderstände R1 und R2 ändert die Diode D ihren Leitzustand in einem gewünschten Umschaltpunkt MPP maximaler Leistung, wie es etwa zum Testen von Photovoltaikkomponenten wünschenswert ist.

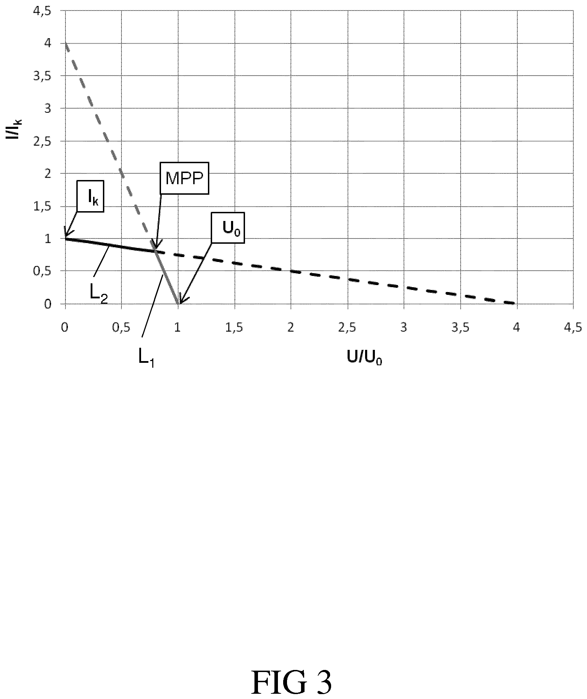

Fig. 3 zeigt eine zu erwartende nichtlineare Strom-Spannungskennlinie der Spannungsquelle 100 aus Fig. 2. Die erste und die zweite lineare Spannungsquelle 110 und 120 liefern den Verlauf der Strom-Spannungskennlinie vom Punkt (0, $I_k$) (Kurzschlussstrom $I_k$ = (U1+U2) / (R1+R2)) bis zum Punkt "MPP" = (k, k) (Kurve L2). Mit dem Faktor k wird im Folgenden die relative Lage des Maximum-Power-Point MPP im Verhältnis zum Kurzschlussstrom bzw. der Leerlaufspannung bezeichnet, wobei zur Vereinfachung der Berechnung angenommen wird, dass das jeweilige Verhältnis für Strom und Spannung gleich ist:

$$k = \frac{U_{MPP}}{U} = \frac{I_{MPP}}{I}$$

Die erste lineare Spannungsquelle 110 liefert den Verlauf der Strom-Spannungskennlinie vom Punkt "MPP" bis zum Punkt "$U_0$" = (1, 0) (Kurve L1). Die lineare Spannungsquellen 110 bzw. die in Reihe geschalteten Spannungsquellen 110, 120 haben die jeweils über den Punkt "MPP" hinausgehende gestrichelt dargestellte Teile der Kurven L1 bzw. L2. Das bedeutet, dass jeweils ein Vielfaches des geforderten Kurzschlussstromes $I_k$ bzw. der geforderten Leerlaufspannung $U_0$ bereitgestellt werden kann (in Fig. 3 beispielhaft jeweils das 4-fache, da U2=3*U1).

Bei der Dimensionierung der in Figur 2 gezeigten Schaltung 100 kann wie folgt vorgegangen werden. Zunächst werden bei gegebenen Faktor k und Leerlaufspannung $U_0$ die Ausgangsgleichspannungen (Leerlaufspannungen) U1, U2 der beiden linearen Spannungsquellen 110 und 120, hier vereinfachend unter Vernachlässigung der Diodenschwellspannung, die typischerweise klein im Vergleich zu den Ausgangsgleichspannungen U1, U2 ist, ermittelt:

$$U1 = U0$$

$$U2 = U0 \times \left( \frac{k}{1-k} - 1 \right)$$

Die Vorwiderstände R1 und R2 lassen sich nun bei geforderten Kurzschlussstromes $I_k$ zu:

$$R1 = \frac{1-k}{k} \times \frac{U0}{Ik}$$

$$R2 = \frac{U1 + U2}{Ik} - R1$$

bestimmen. Bei gegebenen Ausgangsgleichspannung U1, U2 der beiden linearen Gleichspannungsquellen 110 und 120 kann der erzielbare Wert k für die relative Lage des Maximum-Power-Point berechnet werden:

$$k = \frac{U1 + U2}{2U1 + U2}.$$

Mit dieser Dimensionierung ist die Diode D unter Vernachlässigung der relativ geringen Schwellspannung leitend, wenn der Lastwiderstand RL größer als $U_0/I_k$ ist, und sie sperrt wenn der Wert kleiner als $U_0/I_k$ wird. Die Diode D schaltet somit die nichtlineare Strom-Spannungskennlinie am Punkt MPP maximaler Leistung.

Durch Verwendung einer Diode als Schaltelement D kann auf leistungsbegrenzende aktive Bauelemente, wie z.B. Transistoren verzichtet werden. Dies ermöglicht, höhere Prüfleistungen mit nichtlinearer Charakteristik bereitzustellen.

Die Beanspruchung der Umschaltdiode D hinsichtlich Sperrspannung und Strom liegt im Bereich heute üblicher Werte für Leistungsdioden. So ist die auftretende Sperrspannung immer kleiner als die Leerlaufspannung (Prüfspannung) von z.B. max. 1575 V. Zudem ist der durch die Diode D fließende Strom ebenfalls immer kleiner als der Kurzschlussstrom (Prüfstrom) $I_k$.

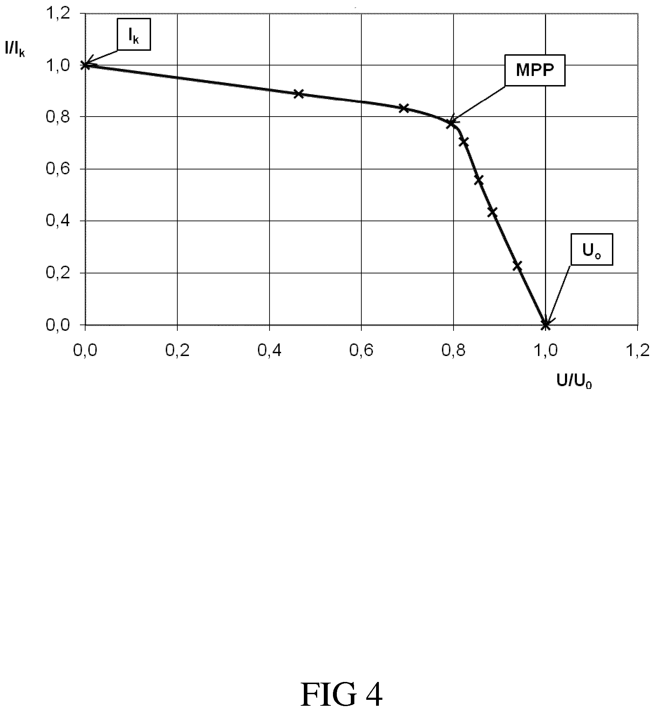

Fig. 4 zeigt eine gemessene nichtlineare Strom-Spannungskennlinie einer Spannungsquelle gemäß Fig. 2 in relativen Einheiten. Durch den Anschluss eines Lastwiderstandes RL mit verschieden großen Widerstandswerten wurden in einem Aufbau der Schaltung 100, wie sie oben mit Bezug zu den Figuren 2 und 3 erläutert wurde, mit einer Leerlaufspannung $U_0$ von 580 V, einem Kurzschlussstrom $I_k$ von 115 A und einem k-Faktor von 0,78 die Messpunkte für Strom und Spannung am Lastwiderstand ermittelt. Um die elektrischen Verluste zu reduzieren, wurde als erste und zweite lineare Spannungsquelle jeweils eine schaltbare lineare Spannungsquelle verwendet. Der Vergleich der ermittelten Strom-Spannungskennlinie mit der in Figur 1 gezeigten gewünschten nichtlinearen Strom-Spannungskennlinie eines Photovoltaikmoduls zeigt, dass deren Charakteristik gut mit der Schaltung 100 nachgebildet werden kann. Insbesondere kann der Umschaltpunkt "MPP" mit einer Genauigkeit von besser als 5% eingestellt werden. Dies ermöglicht aussagekräftige Messungen an Prüflingen.

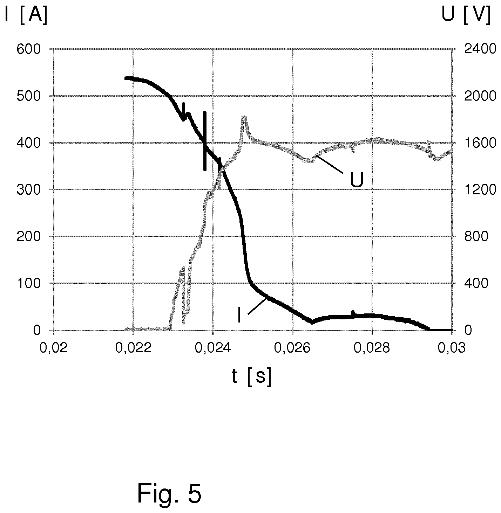

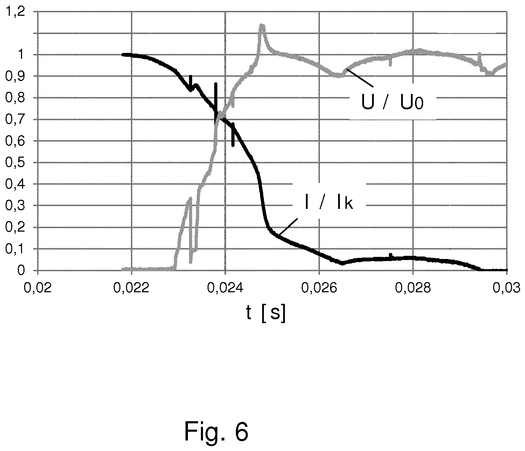

Fig. 5 zeigt eine Prüfmessung an einer 80A-Schmelzsicherung als Prüfling mit einem Simulator 100 wie er oben mit Bezug zu den Figuren 2 und 3 erläutert wurde. Hierbei wurde eine Schaltung 100 mit einer Leerlaufspannung $U_0$ von 1575 V, einem Kurzschlussstrom $I_k$ von etwa 500 A und einem k-Faktor von 0,7 verwendet. Dies ist zur Verdeutlichung in Figur 6 gezeigt, in der der zeitliche Verlauf von Strom und Spannung in relativen Einheiten dargestellt ist. Hier kann der k-Faktor direkt am Schnittpunkt beider Linien abgelesen werden. Die Leistung im Punkt "MPP" maximaler Leistung betrug etwa 386 kW (entspricht ca. 49% von etwa 787 kW). Wie dem dargestellten zeitlichen Verlauf von ermittelten Strom I(t) durch den Prüfling und dem Spannungsabfall U(t) über dem Prüfling in Figur 5 entnommen werden kann, lässt sich das Schmelzen der Schmelzsicherung mittels des Simulators 100 unter prüfrelevanten elektrischen Bedingungen mit guter zeitlicher Auflösung verfolgen. Insbesondere schaltet die verwendete Leistungsdiode als Schaltelement zuverlässig und ausreichend schnell. Es versteht sich, dass als erste und zweite lineare Spannungsquelle jeweils eine schaltbare lineare Spannungsquelle verwendet wurde, um die elektrischen Verluste im Wesentlichen auf die eigentliche Messphase zu beschränken.

Die vorliegende Erfindung wurde anhand von Ausführungsbeispielen erläutert. Diese Ausführungsbeispiele sollten keinesfalls als einschränkend für die vorliegende Erfindung verstanden werden.

**Patentansprüche**

1. Vorrichtung (100) zum Ausgeben eines Gleichspannungssignals mit nichtlinearer Strom-Spannungskennlinie, umfassend:

    - eine erste lineare Spannungsquelle (110), die einen Minuspol (111) und einen Pluspol (112) umfasst und eingerichtet ist, zwischen dem Minuspol (111) und dem Pluspol (112) eine erste Ausgangsgleichspannung auszugeben;
    - eine zweite lineare Spannungsquelle (120), die einen Minuspol (121) und einen Pluspol (122) umfasst und eingerichtet ist, zwischen dem Minuspol (121) und dem Pluspol (122) eine zweite Ausgangsgleichspannung auszugeben, wobei der Pluspol (122) der zweiten linearen Spannungsquelle (120) mit dem Minuspol (111) der ersten linearen Spannungsquelle (110) verbunden ist;
    - einen ersten Signalausgang (101), der über einen ersten Vorwiderstand (R1) mit dem Pluspol (112) der ersten linearen Spannungsquelle (110) verbunden ist;
    - einen zweiten Signalausgang (102), der über einen zweiten Vorwiderstand (R2) mit dem Minuspol (121) der zweiten linearen Spannungsquelle (120) verbunden ist; und
    - ein Schaltelement (D) mit einem ersten Anschluss (103) und einem zweiten Anschluss (104), der mit dem zweiten Signalausgang (102) verbunden ist, wobei der erste Anschluss (103) mit dem Minuspol (111) der ersten linearen Spannungsquelle (110) verbunden ist, und wobei sich das Schaltelement (D) in einem nichtleitenden Zustand befindet, wenn zwischen dem zweiten Anschluss (104) und dem ersten Anschluss (103) eine positive Spannungsdifferenz anliegt.

2. Vorrichtung (100) nach Anspruch 1, wobei das Schaltelement eine Diode (D) umfasst, die in Durchlassrichtung zwischen dem Pluspol (122) der zweiten linearen Spannungsquelle (120) und dem Minuspol (121) der zweiten linearen Spannungsquelle (120) angeordnet ist.

3. Vorrichtung (100) nach Anspruch 1 oder 2, wobei ein Schaltpunkt zwischen dem nichtleitenden Zustand und einem leitenden Zustand des Schaltelements (D) mit einer Genauigkeit von 5% oder besser auf einem Punkt maximaler Leistung der nichtlinearen Strom-Spannungsstromkennlinie eingestellt ist.

4. Vorrichtung (100) nach einem der vorangegangen Ansprüche, wobei der erste Vorwiderstand (R1) und / oder der zweite Vorwiderstand (R2) ein regelbarer Widerstand ist.

**5.** Vorrichtung (100) nach einem der vorangegangen Ansprüche, wobei die erste lineare Spannungsquelle (110) und / oder die zweite lineare Spannungsquelle (120) eine schaltbare lineare Spannungsquelle ist.

**6.** Vorrichtung (100) nach einem der vorangegangen Ansprüche, wobei die zweite Ausgangsgleichspannung größer als die erste Ausgangsgleichspannung ist.

**7.** Vorrichtung (100) nach einem der vorangegangen Ansprüche, wobei die Vorrichtung eingerichtet ist, bei einem Kurzschluss zwischen dem ersten Signalausgang (101) und dem zweiten Signalausgang (102) Gleichspannungssignale von mindestens 100 A bereitzustellen.

**8.** Vorrichtung (100) nach einem der vorangegangen Ansprüche, wobei die Vorrichtung eingerichtet ist, in einem Punkt maximaler Leistung der nichtlinearen Strom-Spannungsstromkennlinie zwischen dem zweiten Signalausgang (102) und dem ersten Signalausgang (101) Gleichspannungssignale von mindestens 100 kW bereitzustellen.

**9.** Vorrichtung (100) nach einem der vorangegangen Ansprüche, wobei die Vorrichtung eingerichtet ist, in unbelastetem Zustand zwischen dem zweiten Signalausgang (102) und dem ersten Signalausgang (101) Gleichspannungssignale von mindestens 1000 V bereitzustellen.

**10.** Simulator (100) zum Prüfen von elektrotechnischen Geräten und Anlagen, insbesondere von Photovoltaikkomponenten (50), umfassend eine Vorrichtung (100) nach einem der vorangegangen Ansprüche, wobei der erste Signalausgang (101) einen ersten Prüfsignalausgang (101) des Simulators (100) bildet, und wobei der zweite Signalausgang (102) einen zweiten Prüfsignalausgang (102) des Simulators (100) bildet.

**Claims**

**1.** A device (100) for outputting a direct voltage signal with nonlinear current-voltage characteristic, comprising:

- a first linear voltage source (110) that comprises a negative pole (111) and a positive pole (112) and is designed for outputting a first direct output voltage between the negative pole (111) and the positive pole (112);
- a second linear voltage source (120) that comprises a negative pole (121) and a positive pole (122) and is designed for outputting a second direct output voltage between the negative pole (121) and the positive pole (122), wherein the positive pole (122) of the second linear voltage source (120) is connected to the negative pole (111) of the first linear voltage source (110);
- a first signal output (101) that is connected to the positive pole (112) of the first linear voltage source (110) via a first series resistor (R1);
- a second signal output (102) that is connected to the negative pole (121) of the second linear voltage source (120) via a second series resistor (R2); and
- a switching element (D) with a first terminal (103) and a second terminal (104) that is connected to the second signal output (102), wherein the first terminal (103) is connected to the negative pole (111) of the first linear voltage source (110), and wherein the switching element (D) is in a non-conductive state when a positive voltage difference exists between the second terminal (104) and the first terminal (103).

**2.** The device (100) according to claim 1, wherein the switching element comprises a diode (D) that is arranged in the forward direction between the positive pole (122) of the second linear voltage source (120) and the negative pole (121) of the second linear voltage source (120).

**3.** The device (100) according to claim 1 or 2, wherein a switching point between the non-conductive state and a conductive state of the switching element (D) is adjusted to a point of maximum power of the nonlinear current-voltage characteristic with an accuracy of 5% or better.

**4.** The device (100) according to any of the preceding claims, wherein the first series resistor (R1) and/or the second series resistor (R2) is a variable resistor.

**5.** The device (100) according to any of the preceding claims, wherein the first linear voltage source (110) and/or the second linear voltage source (120) is a switchable linear voltage source.

**6.** The device (100) according to any of the preceding claims, wherein the second direct output voltage is greater than the first direct output voltage.

**7.** The device (100) according to any of the preceding claims, wherein the device is configured to provide direct voltage signals of at least 100 A between the first signal output (101) and the second signal output (102) during a short circuit.

**8.** The device (100) according to any of the preceding claims, wherein the device configured to provide direct voltage signals of at least 100 kW between the second signal output (102) and the first signal output (101) in a point of maximum power of the non-linear current-voltage characteristic.

9. The device (100) according to any of the preceding claims, wherein the device is configured to provide direct voltage signals of at least 1000 V between the second signal output (102) and the first signal output (101) in a no-load state.

10. A simulator (100) for testing electrotechnical devices and systems, particularly photovoltaic components (50), comprising a device (100) according to any of the preceding claims, wherein the first signal output (101) forms a first test signal output (101) of the simulator (100), and wherein the second signal output (102) forms a second test signal output (102) of the simulator (100).

**Revendications**

1. Dispositif (100) d'émission d'un signal de tension continue présentant une caractéristique tension-courant non linéaire, comprenant :

> - une première source de tension linéaire (110), qui comprend un pôle négatif (111) et un pôle positif (112) et qui est conçue pour délivrer une première tension continue de sortie entre le pôle négatif (111) et le pôle positif (112) ;
> - une deuxième source de tension linéaire (120), qui comprend un pôle négatif (121) et un pôle positif (122) et qui est conçue pour délivrer une deuxième tension continue de sortie entre le pôle négatif (121) et le pôle positif (122), le pôle positif (122) de la deuxième source de tension linéaire (120) étant relié au pôle négatif (111) de la première source de tension linéaire (110) ;
> - une première sortie de signal (101), qui est reliée au pôle positif (112) de la première source de tension linéaire (110) par l'intermédiaire d'une première résistance série (R1) ;
> - une deuxième sortie de signal (102), qui est reliée au pôle négatif (121) de la deuxième source de tension linéaire (120) par l'intermédiaire d'une deuxième résistance série (R2) ; et
> - un élément de commutation (D) pourvu d'une première borne (103) et d'une deuxième borne (104), qui est relié à la deuxième sortie de signal (102), la première borne (103) étant reliée au pôle négatif (111) de la première source de tension linéaire (110), et l'élément de commutation (D) se trouvant dans un état non conducteur, lorsqu'une différence de tension positive est appliquée entre la deuxième borne (104) et la première borne (103).

2. Dispositif (100) selon la revendication 1, l'élément de commutation comprenant une diode (D) qui est agencée dans le sens de passage entre le pôle positif (122) de la deuxième source de tension linéaire (120) et le pôle négatif (121) de la deuxième source de tension linéaire (120).

3. Dispositif (100) selon la revendication 1 ou 2, un point de commutation entre l'état non conducteur et un état conducteur de l'élément de commutation (D) étant ajusté avec une précision supérieure ou égale à 5 % sur un point de puissance maximale de la caractéristique tension-courant non linéaire.

4. Dispositif (100) selon l'une quelconque des revendications précédentes, la première résistance série (R1) et/ou la deuxième résistance série (R2) étant une résistance réglable.

5. Dispositif (100) selon l'une quelconque des revendications précédentes, la première source de tension linéaire (110) et/ou la deuxième source de tension linéaire (120) étant une source de tension linéaire commutable.

6. Dispositif (100) selon l'une quelconque des revendications précédentes, la deuxième tension continue de sortie étant supérieure à la première tension continue de sortie.

7. Dispositif (100) selon l'une quelconque des revendications précédentes, le dispositif étant conçu pour fournir des signaux de tension continue d'au moins 100 A lors d'un court-circuit entre la première sortie de signal (101) et la deuxième sortie de signal (102).

8. Dispositif (100) selon l'une quelconque des revendications précédentes, le dispositif étant conçu pour fournir des signaux de tension continue d'au moins 100 kW dans un point de puissance maximale de la caractéristique tension-courant non linéaire entre la deuxième sortie de signal (102) et la première sortie de signal (101).

9. Dispositif (100) selon l'une quelconque des revendications précédentes, le dispositif étant conçu pour fournir des signaux de tension continue d'au moins 1 000 V dans l'état non sollicité entre la deuxième sortie de signal (102) et la première sortie de signal (101).

10. Simulateur (100) pour le contrôle d'appareils électroniques et d'installations, en particulier de composants photovoltaïques (50), comprenant un dispositif (100) selon l'une quelconque des revendications précédentes, la première sortie de signal (101) formant une première sortie de signal de contrôle (101) du simulateur (100), et la deuxième sortie de signal (102) formant une deuxième sortie de signal de contrôle (102) du simulateur (100).

FIG 1

FIG 2

FIG 3

FIG 4

Fig. 5

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 1457654 A
- DE 2052251
- DE 2018181